# EUROPEAN PATENT APPLICATION

(11) **EP 0 978 886 A2**
(43) Date of publication of application: **09.02.2000**
(21) Application number: 99306260.3
(22) Date of filing: 06.08.1999
(51) Int. Cl.: H01L 41/09

(54) **Ultrasonic motor and electronic appliance with ultrasonic motor**

(30) Priority: 07.08.1998 JP 22479898
(71) Applicant: SEIKO INSTRUMENTS INC., Chiba-shi, Chiba 261 (JP)
(72) Inventor: Iino, Akihiro, Mihama-ku, Chiba-shi, Chiba (JP); Kasuga, Masao, Mihama-ku, Chiba-shi, Chiba (JP); Suzuki, Makoto, Mihama-ku, Chiba-shi, Chiba (JP)
(74) Representative: Sturt, Clifford Mark

(57) **Abstract**

An ultrasonic motor is provided which reduces leakage of the drive force generated by a piezoelectric element and efficiently transmits the drive force to a moving member. The ultrasonic motor 1 is provided with a piezoelectric element 10 to be oscillated by an input drive signal to generate a drive force, and support members 11, 11 for supporting the piezoelectric element 10 on a substrate 7. The support member 11 has a signal supply function to supply the drive signal to the piezoelectric element 10. Accordingly, because there is no necessity of separately providing a signal transmission means, vibration caused by the piezoelectric element 10 leaks less than in a conventional arrangement. Consequently, the ultrasonic motor 1 efficiently transmits drive force to the moving member 12a. Also, the support member 11 is given elasticity by providing a constriction, whereby the support member 11 also provides a press-contact function to press-contact the piezoelectric element 10 with the moving member 12a. In this case, the vibration leakage is further reduced.

## Description

This invention relates to ultrasonic motors used for timepieces, cameras, printers, memory devices and so on and, more particularly, to an ultrasonic motor which is reduced in vibration leakage to efficiently transmit a drive force to a moving member but while being small in size and having improved reliability.

The ultrasonic motor utilizes, as power to move a moving member, elliptic vibration that is a resultant vibration of expansion-and-contraction vibration and flex vibration caused by a piezoelectric element having a drive signal such as an alternating current or voltage applied thereto. Recently, attention has been drawn to the use of ultrasonic motors particularly in the field of micro-mechanics, because of their high electric-to-mechanical energy conversion efficiency.

The ultrasonic motor generally has a piezoelectric element as a drive power source, a signal transmission means for transmitting drive signals to the piezoelectric element, and an elastic member for pressure-contacting the piezoelectric element with the moving member to efficiently transmit drive power to the moving member.

Where such an ultrasonic motor is installed on a circuit board such as a printed circuit board, it is held on the circuit board by using a support member to hold one part of a vibrator having a piezoelectric element for the ultrasonic motor.

However, there has been a necessity for the conventional ultrasonic motor to provide the piezoelectric element with a signal transmission part, such as conductor wires, to apply drive signal to the piezoelectric element. That is, there has been encountered leakage of the expansion-and-contraction vibration and flex vibration caused by the piezoelectric element to other components through both the support member and the signal transmission part. The leakage of expansion-and-contraction vibration and flex vibration also occurs through the elastic member.

As a result, the conventional ultrasonic motor could not efficiently transmit drive force to the moving member, and this impaired the ability to obtain an ultrasonic motor characteristic of high electric-to-mechanical energy conversion efficacy.

Meanwhile, mounting a plurality of elements on the piezoelectric element has prevented reduction in size of the ultrasonic motor and hence increased the factors which lower its reliability.

Accordingly, it is an object of the present invention to provide an ultrasonic motor which has decreased leakage of the drive force produced by the piezoelectric element and which efficiently transmits the drive force to a moving member, wherein size reduction and improvement in reliability can be achieved.

The means to solve the problem is characterized by an ultrasonic motor, as claimed, comprising: a piezoelectric vibrator for oscillating in accordance with an input drive signal and for generating a drive force; and a support member for supporting the piezoelectric vibrator on a substrate; wherein the support member has a signal transmission function to transmit the drive signal to the piezoelectric vibrator.

The support member is formed, for example, of a resin having on a surface thereof a signal line providing a signal transmission function.

Meanwhile, the piezoelectric vibrator is formed, for example, only by a piezoelectric element. Alternatively, a metal vibrator bonded to a piezoelectric element may be used. The drive control may be either of a self-oscillation type or a separate-oscillation type.

According to this invention, because the drive signal is transmitted through the support member to the piezoelectric vibrator, there is no need separately to provide a signal transmission part.

Accordingly, the expansion-and-contraction vibration and flex vibration caused by the piezoelectric vibrator is reduced in its leakage amount as compared to the conventional arrangement. Therefore, the ultrasonic motor according to the invention efficiently transmit a drive force caused by the piezoelectric vibrator to the moving member.

Also, the avoidance of separately providing a signal transmission part offers size reduction for the ultrasonic motor and hence decreases the number of manufacture processes resulting in a reduction in manufacture cost.

The present invention is preferably further characterized in that, in the aforesaid ultrasonic motor, the support member has elasticity, and the piezoelectric vibrator is press-contacted with a moving member by the elastic force of the support member.

The method of providing the support member with elasticity includes using a material such as, for example, a conductive rubber or the like.

According to this modification, the above described benefits are obtained. In addition, in this modification the piezoelectric vibrator is urged onto the moving member by the elasticity of the support member. Accordingly, the drive force caused by the piezoelectric vibrator is transmitted to the moving member with higher efficiency.

The present invention is preferably further characterized in that the support member has a constriction which is thinner than a portion thereof connected to the piezoelectric vibrator.

According to this modification, the provision of the constriction in the support member reduces the vibration transmission area in the support member so that the constriction further reduces the leakage of vibrational energy. Consequently, the ultrasonic motor transmits a drive force to the moving member with higher efficiency. Furthermore, although the support member deforms due to the constriction, it retains the above described benefits.

The present invention is preferably further characterized in that the support member forms a part of the substrate.

According to this modification, because the support member forms part of the substrate, the ultrasonic motor is easy to mount on the substrate.

The present invention is preferably characterized in that the piezoelectric vibrator is provided in a recess formed in the substrate.

In this arrangement, the piezoelectric vibrator is mounted such that the surface of the substrate and the surface of the piezoelectric vibrator are positioned in the same plane, through the support member which is a part of the substrate which has been left unmodified when forming the recess in the substrate.

According to this arrangement, the benefits described above can be obtained. In addition, there is a decrease in the thickness of the ultrasonic motor and the substrate. Accordingly, the applications of the ultrasonic motor are broadened as compared to the conventional ultrasonic motor.

With the piezoelectric vibrator mounted on the support member, the piezoelectric vibrator can be mounted on a substrate in a similar procedure to conventional mounting of transistors or capacitors on a substrate. That is, in the ultrasonic motor of the present invention, it is possible to simultaneously mount a motor and circuits on a substrate by using an existing electric circuit production line. Accordingly, the ultrasonic motor is reduced in manufacturing cost and stabilized in the mounting process. Consequently, the ultrasonic motor is reduced in variation of performance and has improved reliability.

Further, the present invention is preferably characterized in that the support member is provided with at least one part of a drive circuit.

According to this arrangement, because the support member is provided with at least part of a drive circuit, the drive circuit elements required to be mounted on a substrate are decreased, thereby reducing the size of the ultrasonic motor. Also, there is a reduction in the variation in ultrasonic motor performance resulting from connection between the piezoelectric vibrator and the drive circuit. Further, circuit parts can be mounted and adjusted so as to adjust the variation in the motor and circuits, thus improving reliability.

Further, the present invention is preferably characterized in that the support member supports the piezoelectric vibrator at a point corresponding to a node of vibration.

Here, the vibration includes, for example, flex vibration and expansion-and-contraction vibration.

According to this arrangement, the support member holds the piezoelectric vibrator at a point corresponding to a node of flex vibration. Because there is no displacement at the node of vibration, there is a further decrease in the leakage of vibration from the piezoelectric vibrator. Consequently, the ultrasonic motor can transmit a drive force from the piezoelectric vibrator to the moving member with higher efficiency.

Furthermore, the present invention is preferably characterized in that the ultrasonic motor is used in an electronic appliance.

According to this arrangement, because an ultrasonic motor is used in which less vibration leakage occurs as compared to the conventional ultrasonic motor, the ultrasonic motor has an increased output. That is, because the ultrasonic motor and its drive circuit are reduced in size, the electronic appliance can be decreased in size.

Embodiments of the present invention will now be described by way of further example only and with reference to the accompanying drawings, in which:-
Fig. 1 is a view showing a structure of an ultrasonic motor 1 according to a first embodiment of the present invention;
Fig. 2 is a view showing a structure if a piezoelectric vibrator 14 and piezoelectric vibrator 15 with electrodes 13a to 13f used in a piezoelectric element 10 for the ultrasonic motor 1;
Fig. 3 is a schematic view showing operation of the ultrasonic motor 1;
Fig. 4 is a view showing structural elements of an ultrasonic motor 2 as a modification to the ultrasonic motor 1;
Fig. 5 is a view showing the structure of an ultrasonic motor 3 according to a second embodiment of the present invention;
Fig. 6 is a view showing structural elements of an ultrasonic motor 4 as a modification to the ultrasonic motor 3;
Fig. 7 is a view showing the structure of an electronic appliance with ultrasonic motor 5 according to a third embodiment of the present invention;

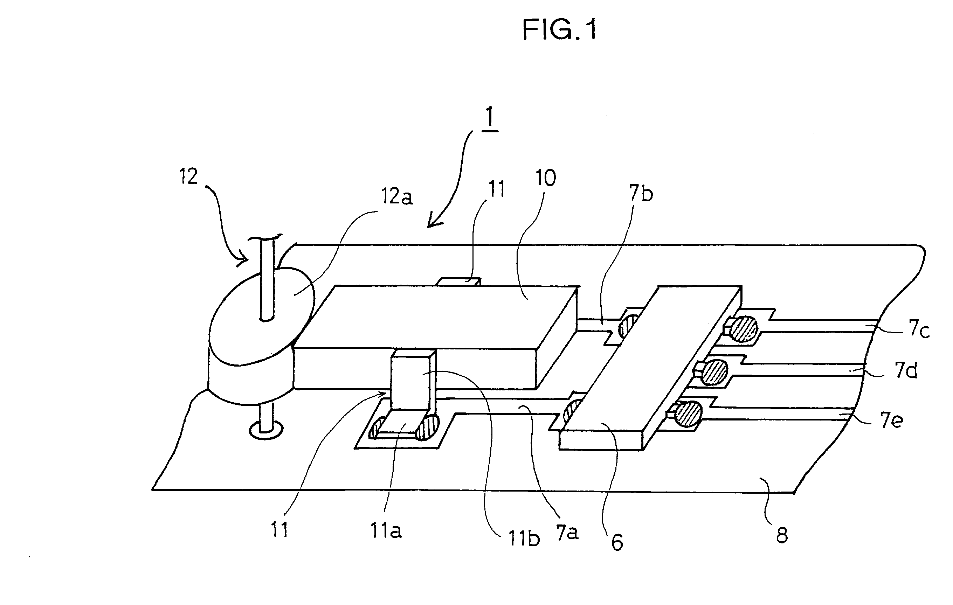

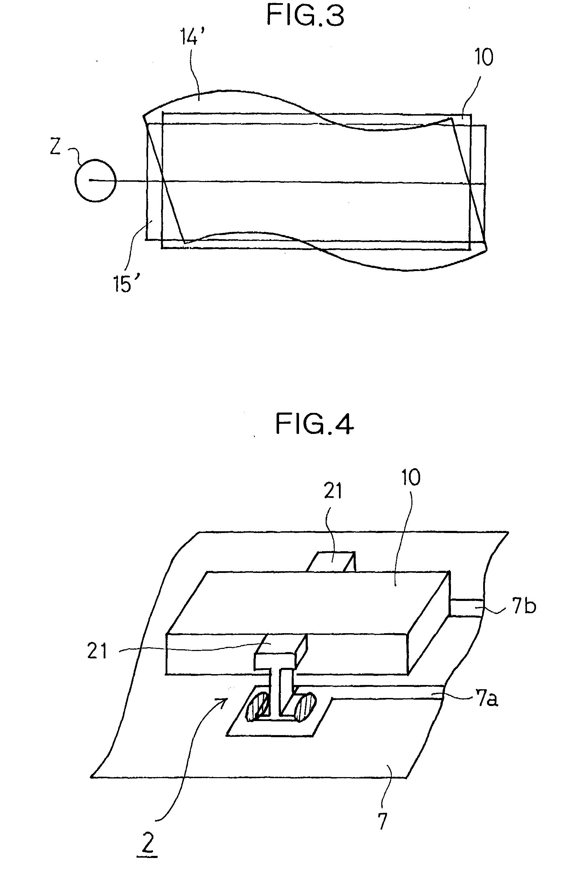

Fig. 1 to Fig. 3 are figures for explaining an ultrasonic motor 1 as a first embodiment of the invention, while Fig. 4 is a figure showing the structure of an ultrasonic motor 2 as a modification of the ultrasonic motor 1.

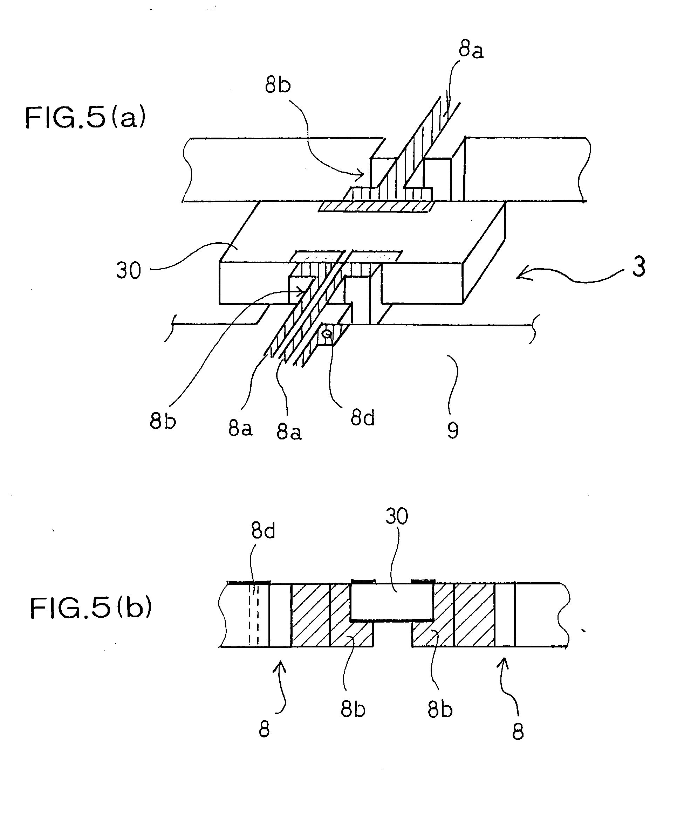

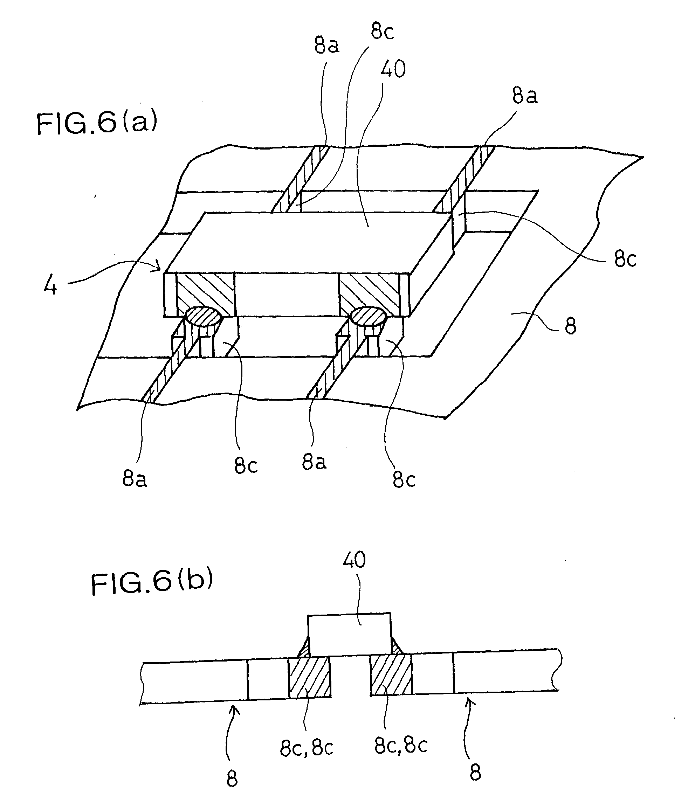

Fig. 5 is a figure for explaining an ultrasonic motor 3 as a second embodiment of the invention, while Fig. 6 is a figure for explaining an ultrasonic motor 4 as a modification of the ultrasonic motor 3.

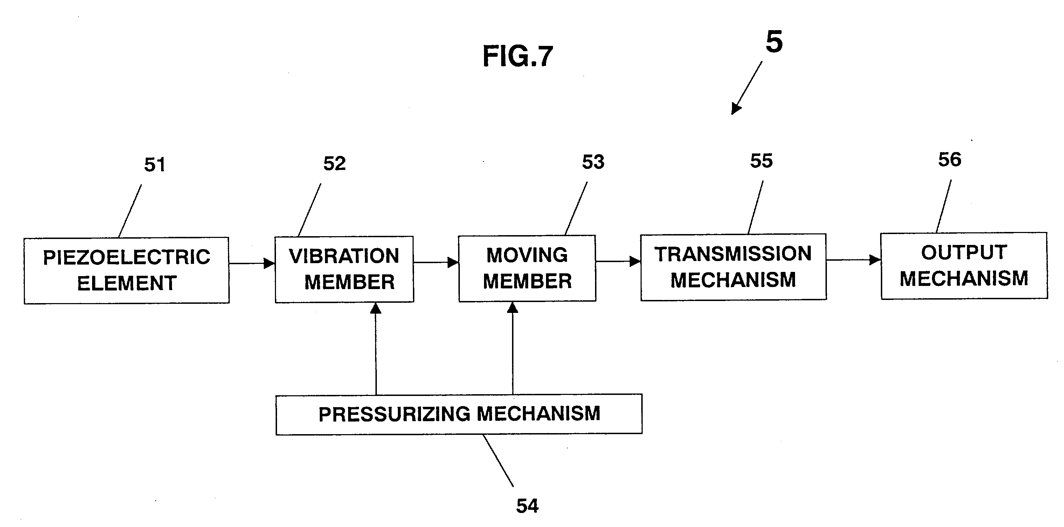

Fig. 7 is a figure for explaining an electronic appliance 5 with an ultrasonic motor as a third embodiment of the invention.

### First Embodiment

Fig. 1 is a view showing the overall structure of an ultrasonic motor 1.

As shown in Fig. 1 the ultrasonic motor 1 has a piezoelectric element 10 (piezoelectric vibrator) which receives an input drive signal X, such as a sine wave, so as to vibrate elliptically. Support members 11, 11 hold the piezoelectric element 10 on a substrate 7 and deliver signals through signal lines 7a, 7b on the substrate 7. A member 12 has a moving member 12a in contact with an end face of the piezoelectric element 10. A drive IC 6 is provided on the substrate 7 to input drive signal X to the piezoelectric element 10 through the signal lines 7a, 7b and the support members 11, 11. The drive IC 6 outputs drive signal X to a predetermined portion of an electrode of the piezoelectric element 10, as hereinafter described, according to a forward drive command, backward drive command and stop command to be input through signal lines 7c, 7d and 7e.

That is, the ultrasonic motor 1 is an ultrasonic motor which causes elliptic vibration at the piezoelectric member 10 end face according to drive signal X input from the drive IC 6 thereby moving the moving member 12a in directions parallel to the end face.

First, the support members 11 are explained in detail.

The support members 11 are formed of a resin, for example, generally in a L-form and each having, for example, three signal lines on a surface thereof. That is, the support members 11, 11 have, for example, totally 6 signal lines which number is the same as the number of electrodes provided on the side faces of the piezoelectric element 10.

A support member 11 has one side 11a fixed on the signal line 7a of the substrate 7, for example, through solder. Also, the support member 11 has the other side 11b fixed on a side face of the piezoelectric element 10, for example, through conductive adhesive in a manner holding a node of flexional vibration.

Meanwhile, the signal line 7a, 7b are a bundle of three signal lines. This number of signal lines is the same as the number of electrodes provided on the piezoelectric element 10 on one side face, as hereinafter described, which signal lines are separately connected respectively to signal lines of the support member 11.

Due to this, the support member 11 supports the piezoelectric element 10 on the substrate 7 and connects between the electrodes of the piezoelectric element 10 and the signal line 7a or signal line 7b.

In this manner, the support member 11 formed with the signal line also serves as a signal transmission means to transmit a signal to the piezoelectric element 10. That is, the number of parts connected to the piezoelectric member 10 is reduced and hence the ultrasonic motor 1 is made smaller in size.

Next, the piezoelectric element 10 will be explained in detail.

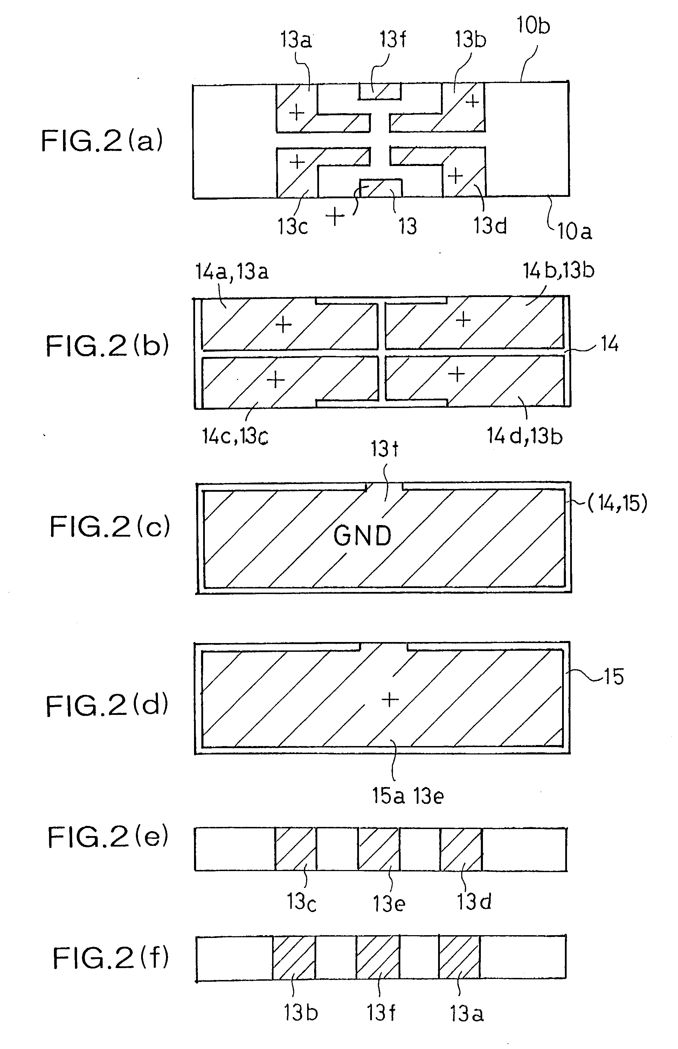

As illustrated in figure 2, the piezoelectric element 10 has a piezoelectric vibrator 14 as a flex vibration source laminated thereon with a piezoelectric vibrator 15 as an expansion-and-contraction vibration source in one body, and has a number of electrodes, namely electrode 13a, electrode 13b, electrode 13c, electrode 13d, electrode 13e and electrode 13f.

These electrodes 13a to 13f are respectively connected to the six signal lines provided on the support members 11, 11, and voltages are to be individually applied thereto.

A projection may be formed in the piezoelectric element 10 generally at the center to contact with and drive the moving member 12a.

Next, the piezoelectric vibrator 14, 15 and the electrodes 13a to 13f will be explained in more detail, with reference to Fig. 2.

Fig. 2(a) is a view showing an arrangement of electrodes in one face of the piezoelectric element 10. Meanwhile, Fig 2(e) is a view showing the position of the electrodes in side face 10a, while Fig. 2(f) is a view showing an arranging position of electrodes in side face 10b.

Fig. 2(b) is a view showing one surface of the piezoelectric vibrator 14, while Fig. 2(d) shows the other surface of the piezoelectric vibrator 15. Meanwhile, Fig. 2(c) is a top view of the piezoelectric vibrator 15.

First explained is a polarization structure in each piezoelectric vibrator.

The piezoelectric vibrator 14 is structured, as shown in Fig. 2(b), so as to be divided into two in a vertical direction and also in a horizontal direction thus giving four regions, i.e. a polarization region 14a, a polarization region 14b, a polarization region 14c and a polarization region 14d that are to be polarized + at their top surfaces in a laminated direction.

The piezoelectric vibrator 15 is structured, as shown in Fig. 2(d), so as to have one polarization region almost over an entire surface so that it can be polarized + ,for example, in an underside in the lamination direction.

Next explained are structures of the electrodes 13a to 13f.

The electrode 13a almost covers a top surface of the polarization region 14a of the piezoelectric vibrator 14, one part of which is extended to a side face 10b. That is, all the polarization regions 14a, 14a ... of a plurality of piezoelectric vibrators 14, 14 ..., at the top surfaces, are to have the same potential by the electrode 13a continuing through extended portions to the side face 10b.

Similarly, the electrode 13b almost covers one surface of the polarization region 14b of the piezoelectric vibrator 14, one part of which is extended to a side face 10b. That is, all the polarization regions 14b, 14b ... of the plurality of piezoelectric vibrators 14, 14 ..., at the one surfaces, are to have the same potential by the electrode 13b continuing through extended portions to the side face 10b.

The electrode 13c almost covers one surface of the polarization region 14c of the piezoelectric vibrator 14, one part of which is extended to a side face 10b. That is, all the polarization regions 14c, 14c ... of the plurality of piezoelectric vibrators 14, 14 ..., at the one surfaces, are to have the same potential by the electrode 13c continuing through extended portions to the side face 10a.

Similarly, the electrode 13d almost covers one surface of the polarization region 14d of the piezoelectric element 14, one part of which is extended to a side face 10b. That is, all the polarization regions 14d, 14d ... of the plurality of piezoelectric vibrators 14, 14 ..., at the one surfaces, are to have the same potential by the electrode 13d continuing through extended portions to the side face 10a.

Also, the electrode 13e almost covers the other surface of the polarization region 15a of the piezoelectric vibrator 15, one part of which is extended to a side face 10a. That is, all the polarization regions 15a, 15a ... of a plurality of piezoelectric vibrators 15, 15 ..., at the other surfaces, are to have the same potential by the electrode 13e continuing through extended portions to the side face 10a.

Further, the electrode 13f is sandwiched between the other surface of the piezoelectric vibrator 14 and the one surface of the piezoelectric vibrator 15. Consequently, the electrode 13f covers all the undersides of the four polarization regions 14a, 14b, 14c and 14d of the piezoelectric vibrator 14, and at the same time the entire top surface of the polarization region 15a of the piezoelectric vibrator 15, and part of which is extended to the side face 10b. That is, all the polarization regions 14d, 14d ... of the plurality of piezoelectric vibrators 14, 14, at the top surfaces, are to have the same potential by the electrode 13f continuing through the extended portions to the side face 10b.

Incidentally, the number of the piezoelectric vibrators 14, 15 may be increased appropriately. In this case, the electrode structure is changed depending on a lamination method.

Now, the operation of the ultrasonic motor 1 is explained with reference to Fig. 3.

If the drive IC 6 receives an externally input drive command signal in a positive direction, through the signal line 7c shown in Fig. 1, it outputs a drive signal X to the electrodes 13a, 13d, 13e and 13f of the piezoelectric element 10 through the signal lines 7a, 7b and the aforesaid signal lines on the support member 11.

Thereupon, in the piezoelectric vibrator 15 the drive signal X is input to the electrode 13e with respect to the electrode 13f acting as a reference electrode. Accordingly, the polarization region 15a expands or contracts. Consequently, the piezoelectric vibrator 15 expands or contracts in a lengthwise direction as shown by the rectangle 15' in Fig. 3.

Simultaneously, in the piezoelectric vibrator 14 the drive signal X is input to the electrodes 13a, 13d with respect to the electrode 13f acting as a reference electrode. Accordingly, the polarization regions 14a, 14d expand. Consequently, the piezoelectric vibrator 14 effects flexional vibration as shown by rectangle 14' in Fig. 3.

At this time, the members connected to the piezoelectric element 10 are only the support members 11, 11. Because no signal transmission means is separately provided, vibration leakage from the piezoelectric element 10 is reduced.

As a result, the expanding-and-contracting vibration of the piezoelectric vibrator 15 and the flexional vibration of the piezoelectric vibrator 14 are combined so that the piezoelectric element 10 at the end face effects elliptic vibration in the Z direction of Fig. 3, thereby moving the moving member 12a shown in Fig. 1 in the Z direction as a positive direction.

Also, if the drive IC 6 receives an externally input drive command in a reverse direction through the signal line 7d, it outputs a drive signal X to the electrodes 13b, 13c, 13e and 13f of the piezoelectric element 10 through the signal lines 7a, 7b and the aforesaid signal lines on the support member 11.

Thereupon, because the electrodes 13b, 13c receive the drive signal X, the flex vibration of the piezoelectric vibrator 14 with respect to the expanding-and-contracting vibration of the piezoelectric vibrator 15 is reversed in direction from the positive direction defined above. Accordingly, the piezoelectric element 10 at the end face effects elliptic vibration in a direction reverse to Z in Fig. 3, thereby moving the moving member 12a shown in Fig. 1 in a reverse direction.

As described above, according to the ultrasonic motor 1 as a first embodiment of the present invention, because the drive signal X is delivered to the piezoelectric element 10 through the signal line 7a by the support member 11, there is no necessity of separately providing a signal transmission part. Accordingly, the expanding-and-contracting vibration and flex vibration of the piezoelectric element 10 are reduced in the amount of leakage as compared to conventional arrangements. Also, because the support members 11 are fixed in a manner holding a flex vibration node, the flex vibration of the piezoelectric element 10 is further reduced in the amount of leakage.

Further, because there is no necessity of separately providing a signal transmission part, the ultrasonic motor 1 is reduced in size and also in the number of manufacture processes, thus reducing manufacturing cost.

Accordingly, the ultrasonic motor 1 effectively transmits a drive force generated by the piezoelectric element 10 to the moving member 12a.

In this embodiment of the present invention, although the support member 11 is made of a resin, the present invention is not limited to this and the support member may be of a metal, for example. If the support member 11 is made of metal, it should be provided corresponding to the number of electrodes.

Further, the support member 11 may be provided with the entire or one part of an electric circuit, e.g. a self-oscillation transmitting circuit. In this case, the number of elements to be provided on the substrate decreases and the substrate area required decreases. Accordingly, the ultrasonic motor 1 is further reduced in size.

The present embodiment may be modified as described below.

Fig. 4 is a view showing the structure of elements of an ultrasonic motor 2 of a first modification to the present embodiment.

The ultrasonic motor 2 as compared with the ultrasonic motor 1, support members 21 in place of the support members 11.

Each support member 21 is formed with a constriction, in a generally I-form, in the shape of the support member 11 with other parts structured similar to those of the support member 11. That is, the support member 21 possesses elasticity. Also, the support members 21 are fixed at side faces of the piezoelectric element 10 so that they can deflect in a direction parallel to the side face of the piezoelectric element 10.

Accordingly, the support members 21 presses the piezoelectric element 10 against the moving member 12a (not shown in Fig. 4).

The ultrasonic motor 2 operates in an equivalent manner to the ultrasonic motor 1. Further, because the piezoelectric element 10 is put in pressure contact with the moving member 12a by the support members 21, there is an increase in frictional force acting between the piezoelectric element 10 and the moving member 12a. Accordingly, the drive force caused on the piezoelectric element 10 is conveyed to the moving member 12a with higher efficiency.

Also, the provision of the constriction decreases the vibration transmission area, further decreasing leakage of vibration through the support member 21. Accordingly, the ultrasonic motor 2 transmits a drive force to the moving member 12a with higher efficiency.

The method of providing elasticity to the support member 21 includes a method of forming a support member 21 of a conductive rubber with the shape of the support member 11 used as it is.

Also, the support member 21 may be provided with the entire or part of an electric circuit such as a self-oscillation transmitting circuit.

### Second Embodiment

Fig. 5 is a view showing the schematic structure of elements of an ultrasonic motor 3.

The ultrasonic motor 3 has a piezoelectric element 30 mounted on a substrate 8, which has a recess, by using support members 8b, 8b that are provided as portions of the substrate 8 in the recess. Also, as shown in Fig 5(b), the piezoelectric member 30 has a top surface almost in a same plane as that of a top surface of the substrate 8. Other, not-shown, structural constituents are almost the same as those of the ultrasonic motor 1.

The support member 8b is structured, as shown in Fig 5(a), to have a support portion for holding the piezoelectric element 30 at a tip end of a terminal extended from the substrate 8. Due to this, the support member 8b is generally in a T-form in section in a parallel direction with the substrate 8. The substrate 8 is formed in a predetermined form, for example by previously preparing a mold for a substrate 8 in a corresponding shape. Also, as shown in Fig. 5(b), the support portion is a convex portion to support an underside of the piezoelectric element 30. Meanwhile, one support member 8b has at a top face a signal line 8a to be connected to a part of the electrodes of the piezoelectric element 30, while the other support member 8b has at a top face a signal line 8a, to be connected to the remainder of the electrodes of the piezoelectric element 30. The number of the signal lines 8a or support members 8b or their positions may be appropriately changed in accordance with the number of electrodes on the piezoelectric element 30 or a vibrational node position.

As shown, the support member 8b is provided so that it holds a flex vibration node on the piezoelectric element 30, similarly to the support member 11.

The piezoelectric element 30 has almost the same structure as that of the piezoelectric element 10 except for the structure of extending electrodes to the side faces.

Here, when required, a signal line is passed through a hole 8d opened in the substrate 8 so that the signal line is connected to an electrode provided on a backside of the piezoelectric element 30.

If a drive signal X is input through signal lines 8a, 8a, 8a to the electrodes of the piezoelectric element 30, the piezoelectric element 30 at the end face effects elliptic vibration to thereby move the moving member (not shown) that is in contact with the end face.

As described above, because in the ultrasonic motor 3 the support members 8b, 8b serves also as a signal transmitting means, the expanding-and-contracting vibration and flex vibration of the piezoelectric element 30 is reduced in leakage amount as compared to conventional arrangements. Further, because the support members 8b are provided in a manner holding a flex vibration node, the flex vibration caused by the piezoelectric element is further reduced in leakage amount.

Accordingly, the ultrasonic motor 3 can efficiently transmit the drive force caused by the piezoelectric element 30 to the moving member.

Also, because the piezoelectric element 30 is provided in the recess of the substrate 8 such that the piezoelectric element 30 and the substrate 8 at their top surfaces are in the same plane, the total thickness of the ultrasonic motor 3 and the substrate 8 are decreased, resulting in small size. Consequently, the application range of the ultrasonic motor 3 is broadened as compared to that of the conventional ultrasonic motor.

The support member 8b may be formed with a constriction in a manner similarly to the support member 21, or the support member 8b may be formed of conductive rubber. In this case, because the piezoelectric element 30 is pressed against the moving member by the support member 8b, further increase in the transmission efficiency of drive force to the moving member can be obtained.

The support member 8b may be provided with an entire or one part of an electric circuit such as a self-oscillation generating circuit. In this case, the number of elements on the substrate decreases and thus decreases the substrate area required. Accordingly, the ultrasonic motor 3 is made further smaller.

The present embodiment may be modified as follows.

Fig. 6 is a view showing the schematic structure of an ultrasonic motor 4 of a first modification according to the present embodiment. The structural constituents not shown have almost the same structure as those of the ultrasonic motor 1.

In Fig. 6, the ultrasonic motor 4 is structured such that the piezoelectric element 40 is fixed, corresponding to nodes of flex vibration of the piezoelectric element 40, on surfaces of the support members 8c, 8c ... provided in a recess of a substrate 8 using, for example, solder, as shown in Fig. 6(b).

The support member 8c has a piezoelectric element support portion provided at a tip of an extension terminal extended from the substrate 8, as shown in Fig. 6(a). The support portion has a top face that is flush with the top face of the substrate 8. Due to this, the sectional form in a parallel direction to the substrate 8 is generally T form.

Also, a predetermined signal line 8a is provided on a surface of the support member 8c corresponding to an electrode of the piezoelectric element 40. The number of signal lines 8a, and the number and position of support members 8c are appropriately changed depending on the number of electrodes of the piezoelectric element 40 or the position of the vibration node.

The piezoelectric element 40 is structured generally the same as the piezoelectric element 10 except for the electrode extended to an end face.

As described above, in the ultrasonic motor 4 leakage of the expansion-and-contraction and flex vibration caused by the piezoelectric element 40 is decreased as compared to the conventional arrangement, similarly to the ultrasonic motor 1. Furthermore, because the support member 8c is provided in a manner holding a flex vibration node of the piezoelectric element 40, the leakage of the flex vibration caused by the piezoelectric element 40 is further reduced.

Accordingly, the ultrasonic motor 4 efficiently delivers a drive force produced by the piezoelectric element 40 to the moving member.

Also, the piezoelectric element 40 is mounted through solder on the surfaces of the support members 8c. Accordingly, where for example the circuit board 8 is formed by a printed board, it is possible to mount the piezoelectric element 40 on the circuit board 8 in a similar procedure to conventional mounting of a transistor or capacitor on the board. That is, the ultrasonic motor 4 allows on-board mounting using an existing electric circuit production line, reducing mounting cost and improving reliability.

The support member 8c may be provided with a constriction similarly to the support member 21 or the support member 8c may be formed of a conductive rubber. In this case, because the piezoelectric element 40 is pushed against the moving member by the support member 8c, the transmission efficiency of drive force to the moving member further improves.

Also, the support member 8c may be provided with an entire or one part of an electric circuit, such as a self-oscillation circuit.

### Third Embodiment

Fig. 7 is a block diagram of an electronic appliance with ultrasonic motor 5 as an example of the ultrasonic motor of the present invention being applied to an electronic appliance.

An electronic appliance with ultrasonic motor 5 is realized by providing a piezoelectric element 51 treated by a predetermined polarization process, a vibration member 52 joined to an piezoelectric element 51, a moving member 53 to be moved by the vibration member 52, a pressurizing mechanism 54 for applying pressure to the vibration member 52 and moving member 53, a transmission mechanism 55 movably interlinked to the moving member 53, and an output mechanism 56 to be moved based on operation of the transmission mechanism 55.

The pressurizing mechanism 54 is, for example, provided by the support member 21.

Here, the electronic appliance with ultrasonic motor 5 includes, for example, electronic timepieces, measuring instruments, cameras, printers, printing machines, machine tools, robots, moving apparatuses, memory devices and so on.

Also, the piezoelectric vibrator 51 uses, for example, piezoelectric elements 10, 20, 30. Also, the transmission mechanism 55 uses, for example, a transmission wheel, such as a gear, friction wheel, or the like. The output mechanism 56 is used as, for example, in a camera as a shutter drive mechanism or lens drive mechanism, and in an electronic timepiece as a pointer drive mechanism or calendar drive mechanism. Where used in a memory device, the output mechanism is used in a head drive mechanism for driving a head to read and write information from and to a memory medium within the information memory device. In a machine tool, the output mechanism is used in a tool feed mechanism or work feed mechanism.

Because this electronic appliance with ultrasonic motor 5 uses an ultrasonic motor according to the invention having a higher output as compared to the conventional ultrasonic motor, the ultrasonic motor and its drive circuits are reduced in size. Accordingly, the electronic appliance is smaller in size as compared to the conventional electronic appliance. Also, where a self-oscillation drive is employed as a method to drive the ultrasonic motor, it is possible to further reduce the size of an electronic appliance with ultrasonic motor 5.

If an output axis is provided for the moving member 53 to make a structure having a power transmission mechanism to transmit torque through the output axis, a drive mechanism is structured by a single ultrasonic motor.

According to this invention, because the drive signal is transmitted through the support member to the piezoelectric vibrator, there is no need to separately provide a signal transmission part. Accordingly, the expansion-and-contraction vibration and flex vibration caused by the piezoelectric vibrator is reduced in leakage amount as compared to the conventional arrangement. Therefore, the ultrasonic motor according to the invention efficiently transmits a drive force caused by the piezoelectric vibrator to the moving member.

Also, the avoidance of separately providing a signal transmission part offers size reduction for the ultrasonic motor and hence decreases the number of manufacture processes resulting in reduction in manufacture cost.

Further, according to this embodiment, the advantages described above are obtained. In addition, the piezoelectric vibrator is urged on the moving member by the elasticity of the support member. Accordingly, the drive force caused on the piezoelectric vibrator is transmitted to the moving member with higher efficiency.

Further, according to this embodiment, the provision of the constriction in the support member reduces the vibration transmission area in the support member so that the constriction reduces the leakage of vibration furthermore. Consequently, the ultrasonic motor transmits a drive force to the moving member with higher efficiency. Furthermore, the support member has elasticity due to the constriction, and has an operation equivalent to that described above.

Further, according to this embodiment, because the support member is one part of the substrate, the ultrasonic motor is easy to mount on the substrate.

Further, according to this embodiment, the above described advantages are obtained. In addition, there is a decrease in thickness of the ultrasonic motor and the substrate. Accordingly the application of the ultrasonic motor is broadened as compared to the conventional ultrasonic motor.

Further, according to this embodiment, the above described advantages are obtained. In addition, because the piezoelectric vibrator is mounted on the support member, the piezoelectric vibrator can be mounted on a substrate in a similar procedure to conventional mounting of transistors or capacitors on a substrate. That is, in the ultrasonic motor of the present embodiment, it is possible to simultaneously mount a motor and circuits on a substrate by using an existing electric circuit production line. Accordingly, the ultrasonic motor is reduced in mounting cost and stabilized in mounting process.

Further, according to this embodiment, because the support member is provided with at least part of a drive circuit, there is a reduction of variation in ultrasonic motor performance resulting from mounting of the piezoelectric vibrator and the drive circuit, thus improving the reliability.

Further, according to this embodiment, because the support member holds the piezoelectric vibrator at a point corresponding to a node of flex vibration, there is a further decrease in the leakage of vibration caused by the piezoelectric vibrator. Consequently, the ultrasonic motor can transmit a drive force caused by the piezoelectric vibrator to the moving member with higher efficiency.

Further, according to this embodiment, because the aforesaid ultrasonic motor is used in which less vibration leakage occurs as compared to the conventional ultrasonic motor, the ultrasonic motor is increased in output. That is, the ultrasonic motor and its drive circuit can be reduced in size, hence the electronic appliance with the ultrasonic motor is decreased in size.

## Claims

1. An ultrasonic motor, comprising:
a piezoelectric vibrator for oscillating in accordance with an input drive signal and for generating a drive force; and
a support member for supporting the piezoelectric vibrator on a substrate;
wherein
the support member has a signal transmission function to transmit the drive signal to the piezoelectric vibrator.

2. An ultrasonic motor according to claim 1, wherein the support member has elasticity, and the piezoelectric vibrator is press-contacted with a moving member by the elastic force of the support member.

3. An ultrasonic motor according to claim 1, wherein the support member has a constriction which is thinner than a portion connected to the piezoelectric vibrator.

4. An ultrasonic motor according to claim 1, wherein the support member is a part of the substrate.

5. An ultrasonic motor according to claim 4, wherein the piezoelectric vibrator is provided in a recess formed in the substrate.

6. An ultrasonic motor according to claim 4, wherein the piezoelectric vibrator is mounted on the support member.

7. An ultrasonic motor according to claim 1, wherein the support member is provided with at least one part of a drive circuit.

8. An ultrasonic motor according to claim 1, wherein the support member supports the piezoelectric vibrator at a point corresponding to a node of vibration caused thereon.

9. An electronic appliance having an ultrasonic motor according to claim 1.
